# EUROPÄISCHE PATENTSCHRIFT

(11) **EP 2 132 771 B1**
(45) Veröffentlichungstag und Bekanntmachung des Hinweises auf die Patenterteilung: **12.04.2017**
(21) Anmeldenummer: 08716766.4
(22) Anmeldetag: 07.02.2008
(51) Int. Cl.: H01L 21/48

(54) **VERFAHREN ZUR HERSTELLUNG EINER KERAMISCHEN MEHRLAGEN-SCHALTUNGSANORDNUNG UND ENTSPRECHENDE SCHALTUNGSLAGE UND MEHRLAGEN-SCHALTUNGSANORDNUNG**
METHOD FOR THE PRODUCTION OF A CERAMIC MULTI-LAYER CIRCUIT ARRANGEMENT, AND MULTI-LAYER AND MULTI-LAYER CIRCUIT ARRANGEMENT PRODUCED USING SAID METHOD
PROCEDE DE REALISATION DE DISPOSITIF DE MONTAGE CERAMIQUE MULTICOUCHE ET& xA;MULTICOUCHE ET DISPOSITIF DE MONTAGE MULTICOUCHE CORRESPONDANT

(30) Priorität: 30.03.2007 DE 102007015399
(43) Veröffentlichungstag der Anmeldung: 16.12.2009
(73) Patentinhaber: Robert Bosch GmbH, 70442 Stuttgart (DE)
(72) Erfinder: EGERTER, Juergen, 72766 Reutlingen (DE); ROETHLINGSHOEFER, Walter, 72766 Reutlingen (DE); WERNER, Markus, 73779 Deizisau (DE)
(86) Internationale Anmeldenummer: PCT/EP2008/051485
(87) Internationale Veröffentlichungsnummer: WO 2008/119582

(56) Entgegenhaltungen:
- EP-A- 0 329 973
- US-A- 6 085 413

## Beschreibung

### STAND DER TECHNIK

Die vorliegende Erfindung betrifft ein Verfahren zur Herstellung einer keramischen Mehrlagen-Schaltungsanordnung und entsprechende Mehrlagen-Schaltungsanordnung.

Durch das sogenannte LTCC-Verfahren (Low Temperature Co-Fired Ceramic) sind keramische Verdrahtungsträger im Mehrlagenaufbau herstellbar. Als Ausgangsbasis dient ein flexibles Tape bzw. eine flexible Folie, welche aus einem Gemisch aus Glas, Keramik und organischen Lösungsmitteln besteht.

In einem ersten Schritt zur Herstellung eines LTCC-Verdrahtungsträgers wird mit dem Zuschnitt der Folien für eine entsprechende Anzahl von Lagen begonnen. In einem zweiten Schritt werden die einzelnen Lagen mechanisch bearbeitet, d.h., es werden Justage- und Durchkontaktierlöcher (Vias) in die Tapelagen gestanzt. In einem dritten Schritt erfolgen ein Via-Füllungsdruck und die Aufbringung von Metallisierungen mittels eines Siebdruckprozesses unter Verwendung einer geeigneten leitfähigen Paste. In einem vierten Schritt erfolgt ein Verpressen der einzelnen Lagen und schliesslich in einem fünften Schritt ein Sintern bei ca. 850°C bis 900°C. Beim Sintern schrumpft das LTCC-Material um ca. 15% in z-Richtung. Seit 1995 ist es möglich, ein Schrumpfen in x/y-Richtung von nahezu Null zu erzielen. In weiteren Schritten werden auf der Rückseite Widerstände aufgebracht und die Leiterbahnen der Vorderseite mit Platinschichten versehen.

Durch die Möglichkeit, die Folienlagen vor dem Sintern einzeln und in verschiedener Weise zu bearbeiten, können LTCC-Verdrahtungsträger mit vielfältigen Formen und Aufbauten realisiert werden. LTTC-Verdrahtungsträger eignen sich insbesondere für Schaltungen mit hohen bzw. tiefen Umgebungstemperaturen und starker Temperaturwechselbeanspruchung, da die LTCC auch als Konstruktionselement im Packaging verwendet werden kann. Insbesondere im Automobilbereich stellen LTCC-Verdrahtungsträger eine kostengünstige und zuverlässige Lösung für große Stückzahlen bereit. Ein gewisser Nachteil besteht darin, dass die organischen Stoffe, welche zunächst über aufwändige Zwischenstufen zur Materialaufbereitung in die flexiblen Folien bzw.in die Leiterbahnpasten eingearbeitet wurden, verbrannt werden und somit keine Wertschöpfung am Teil darstellen.

Derartige Verfahren zur Herstellung einer keramischen Mehrlagenschaltung sind aus der DE 196 15 787 A1 und der DE 198 17 359 A1 bekannt. Die DE 196 38 195 A1 offenbart eine dielektrische Paste zur Verwendung bei der Herstellung keramischer Mehrlagenschaltungen. Aus US6085413 ist ein Sprühverfahren zur Herstellung von Schaltungsträgern bekannt.

### VORTEILE DER ERFINDUNG

Das erfindungsgemäße Verfahren zur Herstellung einer keramischen Mehrlagen-Schaltungsanordnung nach Anspruch 1 bzw. die entsprechende Schaltungslage nach Anspruch 11 weisen den Vorteil auf, dass sie im Vergleich zu den bekannten LTCC-Verfahren ohne die aufwändigen Zwischenstufen bei der Materialverarbeitung auskommen, da die Pulver (Metalle, Halbmetalle, Metalloxide, Dielektrika) direkt mit geeigneten Prozessen verarbeitbar sind.

Die erfindungsgemäße Mehrlagen-Schaltungsanordnung wird schichtweise durch Abscheiden von Pulvermaterialien durch Sprühen über Düsen aufgetragen. Dabei werden wechselweise leitfähige Materialien (ggf. verschiedener Leitfähigkeiten) und isolierende Materialien in Pulverform aufgetragen. Zweckmäßigerweise werden die Pulver in einen rieselfähigen Zustand gebracht, beispielsweise durch gängige Verfahren des Pulver-Coatings. Nach der Schichtung der verschiedenen Lagen wird die Mehrlagen-Anordnung in einem Werkzeug verpresst und anschließend in einem Brennofen gebrannt, um zur fertigen Mehrlagen-Schaltungsanordnung zu gelangen.

Da die Teileherstellung mit kurzen Durchlaufzeiten im Single-Flow erfolgt, ist eine sofortige Umsetzung der CAD-Daten in Hardware durch geeigneten Datentransfer und entsprechende Maschinenkonzeption möglich. Die Anzahl der Lagen ist durch den Aufbau in-situ praktisch nicht limitiert, die Form des Substrats ist frei wählbar. Die Aufnahme von dreidimensionalen Strukturen ist durch die Schichtung möglich. Ein aufwändiges Austreiben von organischen Bestandteilen wie bei der LTCC-Technik ist während des Brennprozesses nicht notwendig, weshalb kurze Brennprofile (typischerweise 0,5 - 3 Stunden) anwendbar sind. Das Coating der Pulver lässt sich vorzugsweise beim Hochrampen auf die endgültige Brenntemperatur durch Einschieben einer kurzen Plateauphase im Temperaturbereich 200 - 500°C erreichen. Die Reduzierung der nicht wertschöpfenden Prozesse, insbesondere in der Materialherstellung, führt zu drastischen Kostenvorteilen und zu einer vereinfachten Prozessführung. Beispielsweise kann als keramisches Pulver Al₂O₃-Glaspulver eingesetzt werden und als leitfähiges Pulver Silberpulver.

Weiterhin denkbar ist auch der Einsatz von Stereolithographie mittels eines Lasers, um eine lokale Haftung des Pulvers beim Auftrag von sehr feinen Strukturen zu ermöglichen.

Die in den Unteransprüchen aufgeführten Merkmale beziehen sich auf vorteilhafte Weiterbildungen und Verbesserungen des jeweiligen Gegenstandes der Erfindung.

### ZEICHNUNGEN

Ein Ausführungsbeispiel der Erfindung ist in der Zeichnung dargestellt und in der nachfolgenden Beschreibung näher erläutert.

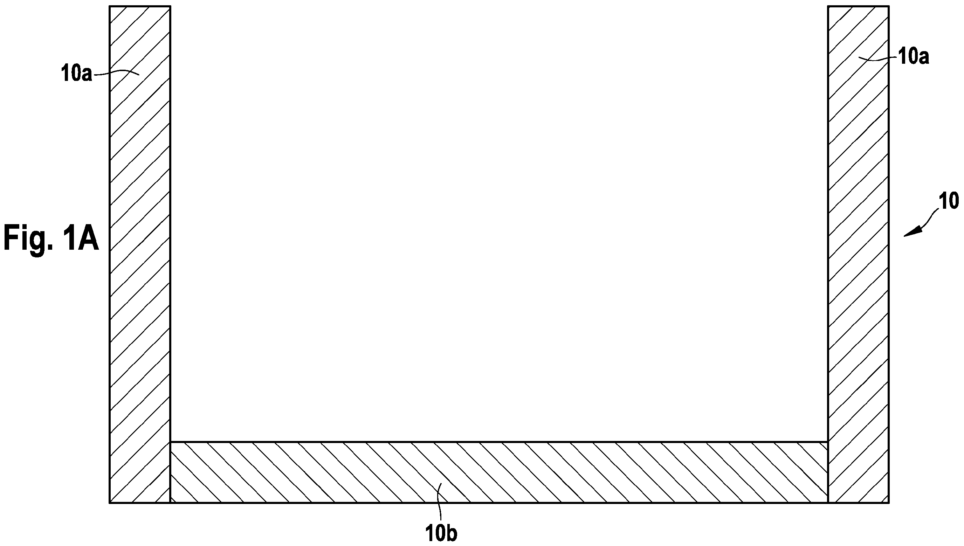

- Fig. 1A-F: zeigen schematische Querschnitte zur Illustration eines Verfahrens zur Herstellung einer keramischen Mehrlagen-Schaltungsanordnung gemäß einer Ausführungsform der vorliegenden Erfindung.

### BESCHREIBUNG VON AUSFÜHRUNGSBEISPIELEN

Fig. 1A-F zeigen schematische Querschnitte zur Illustration eines Verfahrens zur Herstellung einer keramischen Mehrlagen-Schaltungsanordnung gemäß einer Ausführungsform der vorliegenden Erfindung.

In Fig. 1A bezeichnet Bezugszeichen 10 einen Laminierrahmen, welcher Seitenwände 10a und einen Boden 10b aufweist. Der Boden 10b dient beim nachfolgenden Schichtungsprozess der einzelnen Schaltungslagen als Substrat, wobei die Seitenwände 10a für eine seitliche Begrenzung der Schaltungslagen dienen.

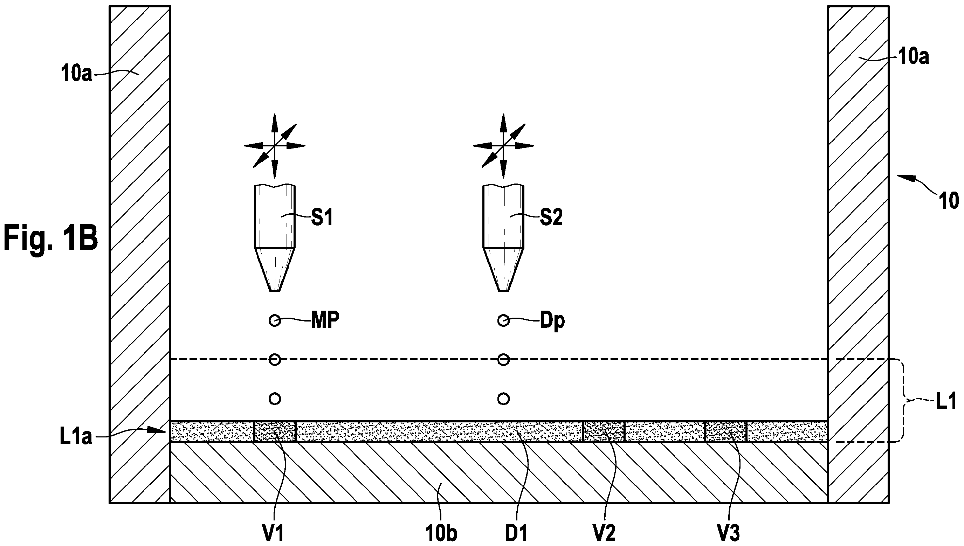

Weiter mit Bezug auf Fig. 1B wird zur Herstellung einer ersten Schaltungslage L1 eine erste Unter-Schaltungslage L1a in einem Pulversprühverfahren auf den Boden 10b aufgetragen. Bei dem Pulversprühverfahren werden ein erster Sprühkopf S1 zum Aufsprühen eines mit einem Coating versehenen rieselfähigen Metallpulvers MP aus Silberpulver und ein zweiter Sprühkopf S2 zum Aufsprühen eines mit einem Coating versehenen rieselfähigen Keramikpulvers Dp aus Al₂O₃₋-Glas vorgesehen. Die Sprühköpfe S1, S2 sind beweglich, um ein sequentielles Abfahren der Strukturen zu ermöglichen. Das Aufsprühen des Metallpulvers und des Keramikpulvers kann - je nach Konsistenz und Beschaffenheit der Pulver - entweder gleichzeitig oder nacheinander erfolgen.

Typische Partikelgrößen der beiden Pulver liegen im Bereich 1 - 5 µm. Eine typische Schichtdicke der Unter-Schaltungslage L1a liegt im Bereich 10 - 50 µm.

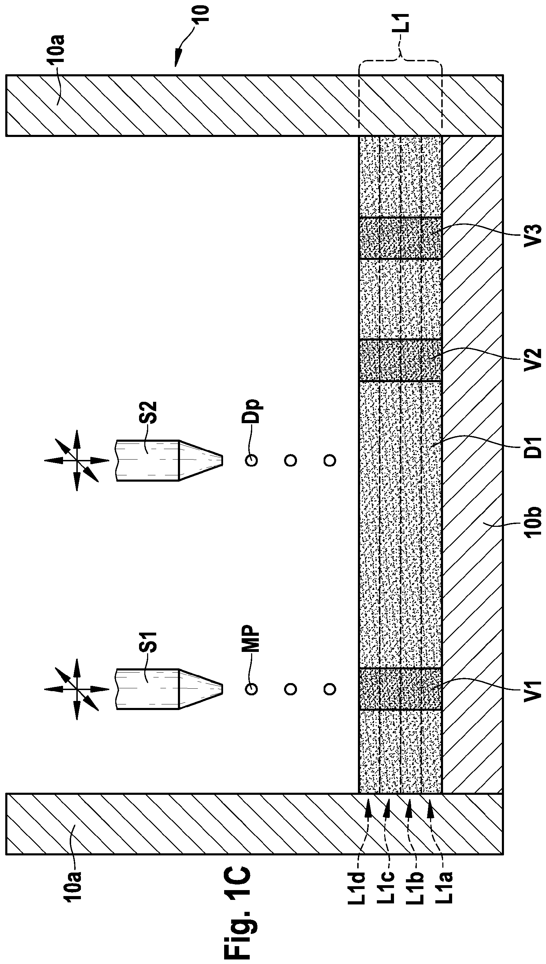

Wie in Fig. 1C dargestellt, werden anschließend identische Unter-Schaltungslagen L1b, L1c, L1d durch das besagte Sprühverfahren aufgetragen, um die erste Schaltungslage L1 zu vervollständigen. Die erste Schaltungslage wie die jeweiligen Unter-Schaltungslagen L1a, L1b, L1c, L1d weisen Durchkontaktierungen V1, V2, V3 aus dem leitfähigen Metallpulver und einen isolierenden Bereich D1 aus dem Keramikpulver auf.

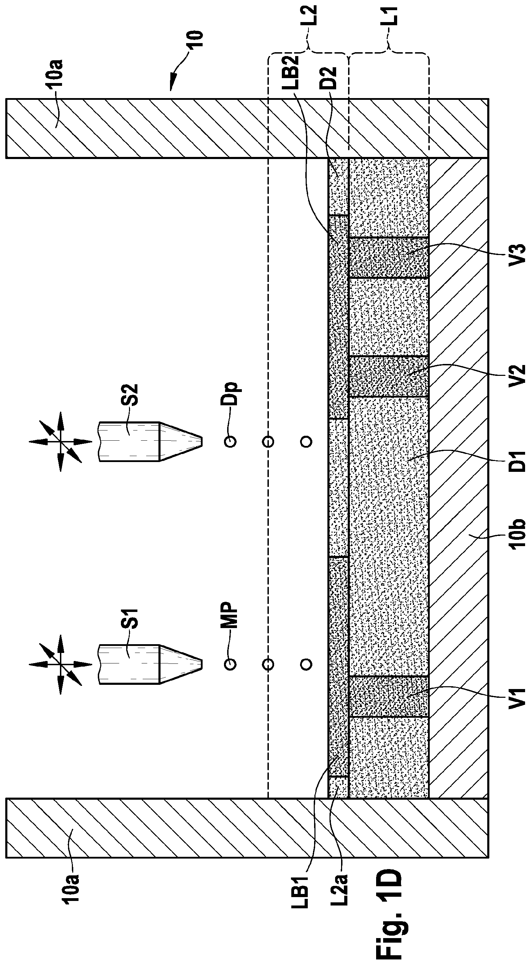

Weiter mit Bezug auf Fig. 1D wird eine Unter-Schaltungslage L2a einer zweiten Schaltungslage L2 durch das besagte Pulversprühverfahren aufgetragen. Diese Unter-Schaltungslage weist Leiterbahnbereiche LB1, LB2 aus dem Metallpulver und einen isolierenden Bereich D2 aus dem Keramikpulver auf.

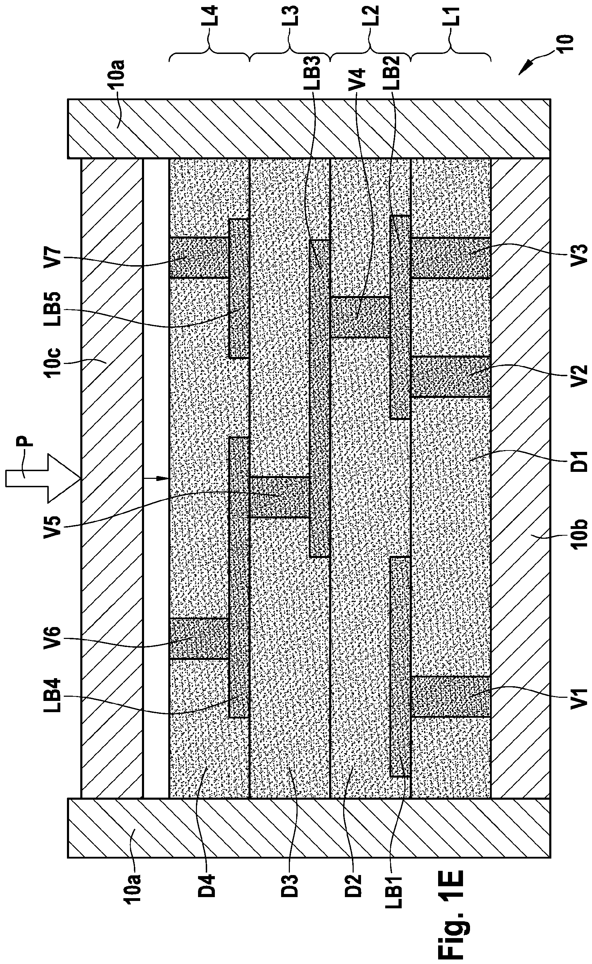

Weiter mit Bezug auf Fig. 1E ist dargestellt, dass die fertig geschichtete Mehrlagen-Schaltungsanordnung gemäß der beschriebenen Ausführungsform insgesamt vier Schaltungslagen L1, L2, L3, L4 aufweist, wobei in der zweiten Schaltungslage neben den Leiterbahnbereichen LB1, LB2 eine Durchkontaktierung V4 auf den Leiterbahnbereich LB2 aufgesetzt ist. In der dritten Schaltungslage L3 sind ein Leiterbahnbereich LB3 und eine darauf aufgesetzte Durchkontaktierung V5 vorgesehen, welche von einem isolierenden Bereich D3 umgeben sind. In der vierten und obersten Schaltungslage L4 sind Leiterbahnbereiche LB4, LB5 vorgesehen, auf denen Durchkontaktierungen V6, V7 aufgebracht sind, wobei der isolierende Bereich dieser vierten Schaltungslage L4 mit Bezugszeichen D4 bezeichnet ist. Nach Fertigstellen der Schichtung der Schaltungslagen L1 - L4 durch das besagte Pulversprühverfahren erfolgt ein Verpressen der geschichteten Schaltungslagen L1, L2, L3, L4 unter Zuhilfenahme eines Deckels 10c des Laminierrahmens 10 und einer entsprechenden Pressvorrichtung. Bei dem Verpressen wird typischerweise ein Druck P der Größenordnung 100 bis einige 100 N/mm² angewendet.

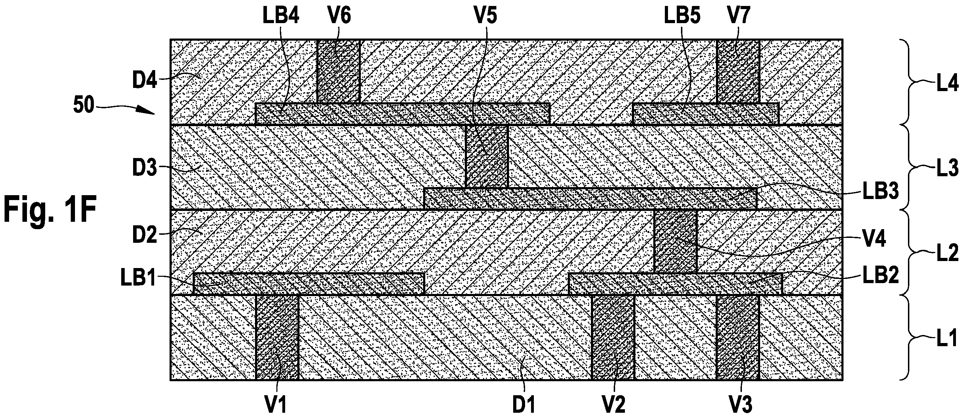

In einem darauffolgenden Prozessschritt, der in Fig. 1F dargestellt ist, erfolgt ein Sinterprozess in einem Ofen, bei dem zunächst ein kurzes Plateau im Bereich 200 - 500°C durchfahren wird, um das Coating der Pulver auszubrennen, wonach die Endtemperatur im Bereich 800 - 1000°C, vorzugsweise 900°C, angefahren wird, um die Mehrlagen-Schaltungsanordnung 50 fertig zu stellen.

Obwohl die vorliegende Erfindung vorstehend anhand eines bevorzugten Ausführungsbeispiels erläutert worden ist, ist sie nicht darauf beschränkt, sondern auch in anderen Weisen ausführbar.

Obwohl bei der obigen Ausführungsform die einzelnen Schaltungslagen bzw. Unter-Schaltungslagen alle dieselbe Dicke aufwiesen, ist es selbstverständlich möglich, Schaltungslagen bzw. Unter-Schaltungslagen unterschiedlicher Dicke zu stapeln.

Auch sollte erwähnt werden, dass es möglich ist, nicht nur ein leitfähiges Material und ein isolierendes Material in Pulverform zur Erstellung der Schaltungslagen aufzuspritzen, sondern eine Mehrzahl von Pulvermaterialien unterschiedlicher Leitfähigkeiten, um beispielsweise Widerstände oder andere passive Komponenten in die Schaltungsanordnung einzugliedern.

Auch ist die Erfindung nicht auf die Verwendung eines Laminierrahmens begrenzt, sondern auch für andere Substrate und Verpressverfahren geeignet.

Weiterhin können als Keramikpulver und Metallpulver bzw. leitendes Pulver nicht nur die angegebenen Materialien verwendet werden, sondern sämtliche zur Sprühverarbeitung geeigneten Pulver.

## Patentansprüche

1. Verfahren zur Herstellung einer keramischen Mehrlagen-Schaltungsanordnung mit den Schritten:
sequenzielles Abscheiden einer Mehrzahl von Schaltungslagen (L1-L4) der Mehrlagen-Schaltungsanordnung auf einem Substrat (10b) in einem Pulversprühverfahren, wobei die einzelnen Schaltungslagen (L1-L4) elektrisch leitende Bereiche (V1-V7; LB1-LB5) aus mindestens einem leitfähigen Pulvermaterial (MP) und elektrisch isolierende Bereiche (D1-D4) aus mindestens einem keramischen Pulvermaterial (DP) aufweisen;
Verpressen der abgeschiedenen Mehrzahl von Schaltungslagen (L1-L4); und
thermisches Sintern der verpressten Mehrzahl von Schaltungslagen (L1-L4).

2. Verfahren nach Anspruch 1, wobei ein Laminierrahmen (10; 10a-c) zum Verpressen verwendet wird und das Substrat (10b) zum Abscheiden ein Boden des Laminierrahmens (10; 10a-c) ist.

3. Verfahren nach Anspruch 1 oder 2, wobei in dem Pulversprühverfahren zwei bewegliche Sprühköpfe (S1, S2) zum Aufsprühen der elektrisch leitenden Bereiche (V1-V7; LB1-LB5) aus dem leitfähigen Pulvermaterial (MP) und der elektrisch isolierenden Bereiche (D1-D4) aus dem keramischen Pulvermaterial (DP) verwendet werden.

4. Verfahren nach einem der vorhergehenden Ansprüche, wobei das leitfähige Material (MP) ein Metallpulver mit einem Coating zur Gewährleistung der Rieselfähigkeit ist, welches beim Sintern in einem Temperaturbereich zwischen 200 und 500 °C ausgebrannt wird.

5. Verfahren nach einem der vorhergehenden Ansprüche, wobei das keramische Material (DP) ein Keramikpulver mit einem Coating zur Gewährleistung der Rieselfähigkeit ist, welche beim thermisches Sintern in einem Temperaturbereich zwischen 200 und 500 °C ausgebrannt wird.

6. Verfahren nach einem der vorhergehenden Ansprüche, wobei die Schaltungslagen (L1-L4) mindestens eine Schaltungslage (L1-L4) aufweisen, die durch Abscheiden einer Mehrzahl von Unter-Schaltungslagen (L1a-L1d) aufgebaut wird.

7. Verfahren nach einem der vorhergehenden Ansprüche, wobei das leitfähige Pulvermaterial (MP) und das keramische Pulvermaterial (DP) Partikelgrössen im Bereich 0,1- 5 Mikrometer aufweisen.

8. Verfahren nach einem der vorhergehenden Ansprüche, wobei das Verpressen bei einem Druck (P) von hundert bis einigen hundert N/mm² durchgeführt wird.

9. Verfahren nach einem der vorhergehenden Ansprüche, wobei das thermische Sintern bei einer Temperatur von 800 bis 1000 °C, vorzugsweise 900 °C, durchgeführt wird.

10. Verfahren nach einem der vorhergehenden Ansprüche, wobei die einzelnen Schaltungslagen (L1-L4) mit einer Dicke zwischen 10 und 200 Mikrometern hergestellt werden.

11. Schaltungslage einer Mehrlagen-Schaltungsanordnung, wobei die Schaltungslage (L1) elektrisch leitende Bereiche (V1-V3; LB1-LB2) aus einem verpressten und gesinterten leitfähigen Pulvermaterial (MP) und elektrisch isolierende Bereiche (D1) aus einem verpressten und gesinterten keramischen Pulvermaterial (DP) aufweist,
**dadurch gekennzeichnet, dass** die Schaltungslage (L1) aus mehreren Unter-Schaltungslagen (L1a, L1b, L1c, L1d) gebildet ist.

12. Schaltungslage nach Anspruch 11,
**dadurch gekennzeichnet, dass**
die Unter-Schaltungslagen (L1a, L1b, L1c, L1d) eine Schichtdicke von 10 µm - 50 µm aufweisen.

13. Schaltungslage nach Anspruch 11 oder 12,
**dadurch gekennzeichnet, dass**
die Unter-Schaltungslagen (L1a, L1b, L1c, L1d) unterschiedliche Schichtdicken aufweisen.

14. Keramischen Mehrlagen-Schaltungsanordnung mit mindestens einer Schaltungslage (L1) entsprechend dem Anspruch 11.

## Claims

1. Method for producing a ceramic multilayer circuit arrangement comprising the following steps:
sequentially depositing a plurality of circuit layers (L1-L4) of the multilayer circuit arrangement on a substrate (10b) in a powder spraying method, wherein the individual circuit layers (L1-L4) comprise electrically conductive regions (V1-V7; LB1-LB5) composed of at least one conductive powder material (MP) and electrically insulating regions (D1-D4) composed of at least one ceramic powder material (DP);
pressing the deposited plurality of circuit layers (L1-L4); and
thermally sintering the pressed plurality of circuit layers (L1-L4).

2. Method according to Claim 1, wherein a lamination frame (10; 10a-c) is used for pressing, and the substrate (10b) for depositing is a base of the lamination frame (10; 10a-c).

3. Method according to Claim 1 or 2, wherein, in the powder spraying method, two moveable spray heads (S1, S2) are used for spraying the electrically conductive regions (V1-V7; LB1-LB5) composed of the conductive powder material (MP) and the electrically insulating regions (D1-D4) composed of the ceramic powder material (DP).

4. Method according to any of the preceding claims, wherein the conductive material (MP) is a metal powder having a coating for ensuring flowability, which is fired during sintering in a temperature range of between 200 and 500 °C.

5. Method according to any of the preceding claims, wherein the ceramic material (DP) is a ceramic powder having a coating for ensuring flowability, which is fired during thermal sintering in a temperature range of between 200 and 500°C.

6. Method according to any of the preceding claims, wherein the circuit layers (L1-L4) comprise at least one circuit layer (L1-L4) which is constructed by depositing a plurality of sub-circuit layers (L1a-L1d).

7. Method according to any of the preceding claims, wherein the conductive powder material (MP) and the ceramic powder material (DP) have particle sizes in the range of 0.1-5 micrometers.

8. Method according to any of the preceding claims, wherein the pressing is carried out at a pressure (P) of one hundred to a few hundred N/mm².

9. Method according to any of the preceding claims, wherein the thermal sintering is carried out at a temperature of 800 to 1000°C, preferably 900°C.

10. Method according to any of the preceding claims, wherein the individual circuit layers (L1-L4) are produced with a thickness of between 10 and 200 micrometers.

11. Circuit layer of a multilayer circuit arrangement, wherein the circuit layer (L1) comprises electrically conductive regions (V1-V3; LB1-LB2) composed of a pressed and sintered conductive powder material (MP) and electrically insulating regions (D1) composed of a pressed and sintered ceramic powder material (DP), **characterized in that** the circuit layer (L1) is formed from a plurality of sub-circuit layers (L1a, L1b, L1c, L1d).

12. Circuit layer according to Claim 11,
**characterized in that**
the sub-circuit layers (L1a, L1b, L1c, L1d) have a layer thickness of 10 µm - 50 µm.

13. Circuit layer according to Claim 11 or 12,
**characterized in that**
the sub-circuit layers (L1a, L1b, L1c, L1d) have different layer thicknesses.

14. Ceramic multilayer circuit arrangement comprising at least one circuit layer (L1) according to Claim 11.

## Revendications

1. Procédé pour la fabrication d'un ensemble de circuits céramique multicouche, comprenant les étapes :
dépôt séquentiel d'une pluralité de couches de circuits (L1-L4) de l'ensemble de circuits multicouche sur un substrat (10b) dans un procédé de pulvérisation de poudre, les couches de circuits individuelles (L1-L4) présentant des zones conductrices de l'électricité (V1-V7 ; LB1-LB5) à base d'au moins un matériau pulvérulent (MP) conducteur et des zones électriquement isolantes (D1-D4) à base d'au moins un matériau pulvérulent céramique (DP) ;
pressage de la pluralité déposée de couches de circuits (L1-L4) ; et
frittage thermique de la pluralité pressée de couches de circuits (L1-L4).

2. Procédé selon la revendication 1, dans lequel on utilise pour le pressage un châssis de stratification (10 ; 10a-c) et le substrat (10b) pour le dépôt est un fond du châssis de stratification (10 ; 10a-c).

3. Procédé selon la revendication 1 ou 2, dans lequel on utilise dans le procédé de pulvérisation de poudre deux têtes de pulvérisation mobiles (S1, S2) pour l'application par pulvérisation des zones conductrices de l'électricité (V1-V7 ; LB1-LB5) à partir du matériau pulvérulent conducteur (MP) et des zones électriquement isolantes (D1-D4) à partir du matériau pulvérulent céramique (DP).

4. Procédé selon l'une quelconque des revendications précédentes, dans lequel le matériau conducteur (MP) est une poudre métallique munie d'un enrobage destiné à assurer la coulabilité, qui est détruit par combustion lors du frittage dans une plage de température comprise entre 200 et 500 °C.

5. Procédé selon l'une quelconque des revendications précédentes, dans lequel le matériau céramique (DP) est une poudre céramique munie d'un enrobage destiné à assurer la coulabilité, qui est détruit par combustion lors du frittage dans une plage de température comprise entre 200 et 500 °C.

6. Procédé selon l'une quelconque des revendications précédentes, dans lequel les couches de circuits (L1-L4) comportent au moins une couche de circuit (L1-L4) qui est construite par dépôt d'une pluralité de sous-couches de circuit (L1a-L1d).

7. Procédé selon l'une quelconque des revendications précédentes, dans lequel le matériau pulvérulent conducteur (MP) et le matériau pulvérulent céramique (DP) présentent des tailles de particules dans la plage de 0,1 - 5 micromètres.

8. Procédé selon l'une quelconque des revendications précédentes, dans lequel on effectue le pressage sous une pression (P) de cent à plusieurs centaines de N/mm².

9. Procédé selon l'une quelconque des revendications précédentes, dans lequel on effectue le frittage thermique à une température de 800 à 1 000 °C, de préférence à 900 °C.

10. Procédé selon l'une quelconque des revendications précédentes, dans lequel les couches de circuits individuelles (L1-L4) sont produites en une épaisseur comprise entre 10 à 200 micromètres.

11. Couche de circuit d'un ensemble de circuits multicouche, la couche de circuit (L1) comportant des zones conductrices de l'électricité (V1-V3 ; LB1-LB2) à base d'un matériau pulvérulent (MP) conducteur pressé et fritté et des zones électriquement isolantes (D1) à base d'un matériau pulvérulent (DP) céramique pressé et fritté,
**caractérisée en ce que** la couche de circuit (L1) est constituée de plusieurs sous-couches de circuits (L1a, L1b, L1c, L1d).

12. Couche de circuit selon la revendication 11, **caractérisée en ce que**
les sous-couches de circuits (L1a, L1b, L1c, L1d) présentent une épaisseur de couche de 10 µm - 50 µm.

13. Couche de circuit selon la revendication 11 ou 12,
**caractérisée en ce que**
les sous-couches de circuits (L1a, L1b, L1c, L1d) présentent des épaisseurs de couche différentes.

14. Ensemble de circuits céramique multicouche, comportant au moins une couche de circuit (L1) conforme à la revendication 11.
